# EUROPEAN PATENT APPLICATION

(11) **EP 4 625 015 A1**
(43) Date of publication of application: **01.10.2025**
(21) Application number: 25163498.6
(22) Date of filing: 13.03.2025
(51) Int. Cl.: G02B 6/42, H01L 23/538, H01L 25/16

(54) **DEVICES, SYSTEM, AND MANUFACTURING METHODS FOR INTEGRATED EPIC ARCHITECTURE**

(30) Priority: 18.03.2024 US 202463566892 P; 04.02.2025 US 202519045545
(71) Applicant: Samsung Electronics Co., Ltd., Suwon-si, Gyeonggi-do 16677 (KR)
(72) Inventor: ESLAMPOUR, Hamid, San Jose, CA, 95134 (US)
(74) Representative: Kuhnen & Wacker Patent- und Rechtsanwaltsbüro PartG mbB

(57) **Abstract**

Disclosed herein are systems, methods and device including a first layer with a photonic integrated circuit (104) and a first compute device (102), the photonic integrated circuit (104) having an output port (116) coupled to an optical fiber (114); the first layer may be positioned on a support base (101) in a second layer, while a connecting element (108) may couple the photonic integrated circuit (104) and the first compute device (102). The output port (116) may extend in a direction parallel with the first layer beyond the support base (101).

## Description

### TECHNICAL FIELD

The subject matter disclosed herein relates to packaging. More particularly, the subject matter disclosed herein relates to a technique for connecting between electronic integrated circuits (EICs) and photonic integrated circuits (PICs).

### BACKGROUND

Semiconductor devices may connect to additional devices and circuitry on different substrates. Forming connections between substrates may provide increased computational power. However, forming connections between substrates may cause difficulties. Packaging describes the general method for connecting and integrating multiple computational components together in an integrated unit and may involve multiple different types of integrated circuits on multiple substrates which may combine into a single unit. Packaging may also describe a method for which multiple computational components within a single unit are protected by the use of various techniques to provide thermal, physical and electrical protection It is further noted that background concepts discussed herein are for informational purposes only and are not intended to limit the present disclosure. Nor should the background or field described herein be intended to limit the disclosure herein to a particular use or concept.

### SUMMARY

In an exemplary embodiment, a device includes a first layer with a photonic integrated circuit and a first compute device, the photonic integrated circuit having an output port coupled to an optical fiber. The device may include a second layer with a support base with the first layer positioned on the support base. A connecting element may couple the photonic integrated circuit and the first compute device. The output port may extend in a direction parallel with the first layer beyond the support base. The first compute device may include at least one processing device. The output port may include one or more v-grooves extending in a direction parallel to the first layer. The photonic integrated circuit may include a plug connector configured to receive an optical fiber. The connecting element may be arranged between the first compute device and the photonic integrated circuit, with the connecting element arranged within the support base. A redistribution layer may be arranged between the connecting element, the first compute device and the photonic integrated circuit. The connecting element may be arranged between the first compute device and the photonic integrated circuit within the first layer. An electronic integrated circuit may be positioned on a side of the photonic integrated circuit opposite the support base. An electronic integrated circuit may be arranged between the photonic integrated circuit and the support base.

In an exemplary embodiment, a system may include a redistribution layer and a first layer positioned upon the redistribution layer. The first layer may include a photonic integrated circuit, a first compute device and a connecting element between the photonic integrated circuit and the first compute device. The redistribution layer may couple the photonic integrated circuit to the connecting element, and may couple the first compute device to the connecting element. The photonic integrated circuit may include an optical coupler extending in a direction parallel to the first layer. The first compute device may include a processing device. The photonic integrated circuit may include one or more V-grooves extending in a direction parallel with the first layer. An electronic integrated circuit may be positioned on a side of the photonic integrated circuit opposite the redistribution layer. The optical coupler may be a plug connector to receive an optical fiber in a direction parallel with the first layer. The optical coupler may extend in the first layer in a direction parallel to the first layer beyond the redistribution layer. The first compute device may be an auxiliary processing unit.

In an exemplary embodiment, a method may include forming a first layer with a first connecting element, forming a redistribution layer on the first layer, positioning a first compute device on the redistribution layer, coupling the first compute device to the first connecting element via the redistribution layer, positioning a photonic integrated circuit on the redistribution layer with a portion of the photonic integrated circuit extending beyond the redistribution layer in a direction parallel to the redistribution layer; coupling the photonic integrated circuit to the first connecting element via the redistribution layer; and positioning an electronic integrated circuit on the photonic integrated circuit. The first compute device may include at least one processing unit. An optical fiber may be coupled in a direction parallel to the photonic integrated circuit. The first layer may be positioned on a supporting substrate, and the supporting substrate may be an organic substrate. The photonic integrated circuit may include a v-groove extending in a direction parallel to the first layer.

### BRIEF DESCRIPTION OF THE DRAWING

In the following section, the aspects of the subject matter disclosed herein will be described with reference to exemplary embodiments illustrated in the figures, in which:
FIG. 1 depicts a cross-section view of a hybrid electronic integrated circuit and photonic integrated circuit system according to various embodiments of the subject matter disclosed herein;
FIG. 2 depicts a cross-section view of a hybrid electronic integrated circuit and photonic integrated circuit system according to various embodiments of the subject matter disclosed herein;
FIG. 3 depicts a cross-section view of a hybrid electronic integrated circuit and photonic integrated circuit system according to various embodiments of the subject matter disclosed herein;
FIG. 4 depicts a cross-section view of a hybrid electronic integrated circuit and photonic integrated circuit system according to various embodiments of the subject matter disclosed herein;
FIG. 5A depicts a cross-section view of an example embodiment of a hybrid electronic integrated circuit and photonic integrated circuit system at a first stage of manufacturing;
FIG. 5B depicts a cross-section view of an example embodiment of a hybrid electronic integrated circuit and photonic integrated circuit system at a second stage of manufacturing;
FIG. 5C depicts a cross-section view of an example embodiment of a hybrid electronic integrated circuit and photonic integrated circuit system at a third stage of manufacturing;
FIG. 5D depicts a cross-section view of an example embodiment of a hybrid electronic integrated circuit and photonic integrated circuit system at a fourth stage of manufacturing;
FIG. 5E depicts a cross-section view of an example embodiment of a hybrid electronic integrated circuit and photonic integrated circuit system at a fifth stage of manufacturing;
FIG. 5F depicts a cross-section view of an example embodiment of a hybrid electronic integrated circuit and photonic integrated circuit system at a sixth stage of manufacturing;
FIG. 5G depicts a cross-section view of an example embodiment of a hybrid electronic integrated circuit and photonic integrated circuit system at a seventh stage of manufacturing;
FIG. 5H depicts a cross-section view of an example embodiment of a hybrid electronic integrated circuit and photonic integrated circuit system at an eighth stage of manufacturing;
FIG. 5I depicts a cross-section view of an example embodiment of a hybrid electronic integrated circuit and photonic integrated circuit system at a ninth stage of manufacturing;
FIG. 5J depicts a cross-section view of an example embodiment of a hybrid electronic integrated circuit and photonic integrated circuit system at a tenth stage of manufacturing;
FIG. 5K depicts a cross-section view of an example embodiment of a hybrid electronic integrated circuit and photonic integrated circuit system at an eleventh stage of manufacturing;
FIG. 6 depicts a plan view of a method according to various embodiments of the subject matter disclosed herein;
FIG. 7A depicts a cross-section view of an example embodiment of a hybrid electronic integrated circuit and photonic integrated circuit system at a first stage of manufacturing;
FIG. 7B depicts a cross-section view of an example embodiment of a hybrid electronic integrated circuit and photonic integrated circuit system at a second stage of manufacturing;
FIG. 7C depicts a cross-section view of an example embodiment of a hybrid electronic integrated circuit and photonic integrated circuit system at a third stage of manufacturing;
FIG. 7D depicts a cross-section view of an example embodiment of a hybrid electronic integrated circuit and photonic integrated circuit system at a fourth stage of manufacturing;
FIG. 7E depicts a cross-section view of an example embodiment of a hybrid electronic integrated circuit and photonic integrated circuit system at a fifth stage of manufacturing;
FIG. 7F depicts a cross-section view of an example embodiment of a hybrid electronic integrated circuit and photonic integrated circuit system at a sixth stage of manufacturing;
FIG. 7G depicts a cross-section view of an example embodiment of a hybrid electronic integrated circuit and photonic integrated circuit system at a seventh stage of manufacturing;
FIG. 7H depicts a cross-section view of an example embodiment of a hybrid electronic integrated circuit and photonic integrated circuit system at an eighth stage of manufacturing;
FIG. 7I depicts a cross-section view of an example embodiment of a hybrid electronic integrated circuit and photonic integrated circuit system at a ninth stage of manufacturing;
FIG. 7J depicts a cross-section view of an example embodiment of a hybrid electronic integrated circuit and photonic integrated circuit system at a tenth stage of manufacturing;
FIG. 7K depicts a cross-section view of an example embodiment of a hybrid electronic integrated circuit and photonic integrated circuit system at an eleventh stage of manufacturing;
FIG. 8 depicts a plan view of a method according to various embodiments of the subject matter disclosed herein;
FIG. 9A depicts a cross-section view of an example embodiment of a hybrid electronic integrated circuit and photonic integrated circuit system at a first stage of manufacturing;
FIG. 9B depicts a cross-section view of an example embodiment of a hybrid electronic integrated circuit and photonic integrated circuit system at a second stage of manufacturing;
FIG. 9C depicts a cross-section view of an example embodiment of a hybrid electronic integrated circuit and photonic integrated circuit system at a third stage of manufacturing;
FIG. 9D depicts a cross-section view of an example embodiment of a hybrid electronic integrated circuit and photonic integrated circuit system at a fourth stage of manufacturing;
FIG. 9E depicts a cross-section view of an example embodiment of a hybrid electronic integrated circuit and photonic integrated circuit system at a fifth stage of manufacturing;
FIG. 9F depicts a cross-section view of an example embodiment of a hybrid electronic integrated circuit and photonic integrated circuit system at a sixth stage of manufacturing;
FIG. 9G depicts a cross-section view of an example embodiment of a hybrid electronic integrated circuit and photonic integrated circuit system at a seventh stage of manufacturing;
FIG. 9H depicts a cross-section view of an example embodiment of a hybrid electronic integrated circuit and photonic integrated circuit system at an eighth stage of manufacturing;
FIG. 9I depicts a cross-section view of an example embodiment of a hybrid electronic integrated circuit and photonic integrated circuit system at a ninth stage of manufacturing;
FIG. 9J depicts a cross-section view of an example embodiment of a hybrid electronic integrated circuit and photonic integrated circuit system at a tenth stage of manufacturing;
FIG. 10 depicts a plan view of a method according to various embodiments of the subject matter disclosed herein;
FIG. 11A depicts a plan view of photonic integrated circuits before separation according to various embodiments of the subject matter disclosed herein;
FIG. 11B depicts a side view of photonic integrated circuits before separation according to various embodiments of the subject matter disclosed herein;
FIG. 11C depicts a side view of photonic integrated circuits after separation according to various embodiments of the subject matter disclosed herein;
FIG. 12A depicts a plan view of photonic integrated circuits before separation according to various embodiments of the subject matter disclosed herein;
FIG. 12B depicts a side view of photonic integrated circuits before separation according to various embodiments of the subject matter disclosed herein; and
FIG. 12C depicts a side view of photonic integrated circuits after separation according to various embodiments of the subject matter disclosed herein.

### DETAILED DESCRIPTION

In the following detailed description, numerous specific details are set forth in order to provide a thorough understanding of the disclosure. It will be understood, however, by those skilled in the art that the disclosed aspects may be practiced without these specific details. In other instances, well-known methods, procedures, components and circuits have not been described in detail to not obscure the subject matter disclosed herein.

Reference throughout this specification to "one embodiment" or "an embodiment" means that a particular feature, structure, or characteristic described in connection with the embodiment may be included in at least one embodiment disclosed herein. Thus, the appearances of the phrases "in one embodiment" or "in an embodiment" or "according to one embodiment" (or other phrases having similar import) in various places throughout this specification may not necessarily all be referring to the same embodiment. In this regard, as used herein, the word "exemplary" means "serving as an example, instance, or illustration." Any embodiment described herein as "exemplary" is not to be construed as necessarily preferred or advantageous over other embodiments. Additionally, the particular features, structures, or characteristics may be combined in any suitable manner in one or more embodiments. Similarly, a hyphenated term (e.g., "two-dimensional," "pre-determined," etc.) may be occasionally interchangeably used with a corresponding non-hyphenated version (e.g., "two dimensional," "predetermined, etc.), and a capitalized entry (e.g., "Integrated Chip," "First Substrate," "PIC," etc.) may be interchangeably used with a corresponding non-capitalized version (e.g., "integrated chip," "first substrate," "pic," etc.). Such occasional interchangeable uses shall not be considered inconsistent with each other.

Also, depending on the context of discussion herein, a singular term may include the corresponding plural forms and a plural term may include the corresponding singular form. It is further noted that various figures (including component diagrams) shown and discussed herein are for illustrative purpose only, and are not drawn to scale. For example, the dimensions of some of the elements may be exaggerated relative to other elements for clarity. Further, if considered appropriate, reference numerals have been repeated among the figures to indicate corresponding and/or analogous elements.

The terminology used herein is for the purpose of describing some example embodiments only and is not intended to be limiting of the claimed subject matter. As used herein, the singular forms "a," "an" and "the" are intended to include the plural forms as well, unless the context clearly indicates otherwise. It will be further understood that the terms "comprises" and/or "comprising," when used in this specification, specify the presence of stated features, integers, steps, operations, elements, and/or components, but do not preclude the presence or addition of one or more other features, integers, steps, operations, elements, components, and/or groups thereof.

It will be understood that when an element or layer is referred to as being on, "connected to" or "coupled to" another element or layer, it can be directly on, connected or coupled to the other element or layer or intervening elements or layers may be present. In contrast, when an element is referred to as being "directly on," "directly connected to" or "directly coupled to" another element or layer, there are no intervening elements or layers present. Like numerals refer to like elements throughout. As used herein, the term "and/or" includes any and all combinations of one or more of the associated listed items.

The terms "first," "second," etc., as used herein, are used as labels for nouns that they precede, and do not imply any type of ordering (e.g., spatial, temporal, logical, etc.) unless explicitly defined as such. Furthermore, the same reference numerals may be used across two or more figures to refer to parts, components, blocks, circuits, units, or modules having the same or similar functionality. Such usage is, however, for simplicity of illustration and ease of discussion only; it does not imply that the construction or architectural details of such components or units are the same across all embodiments or such commonly-referenced parts/modules are the only way to implement some of the example embodiments disclosed herein.

Unless otherwise defined, all terms (including technical and scientific terms) used herein have the same meaning as commonly understood by one of ordinary skill in the art to which this subject matter belongs. It will be further understood that terms, such as those defined in commonly used dictionaries, should be interpreted as having a meaning that is consistent with their meaning in the context of the relevant art and will not be interpreted in an idealized or overly formal sense unless expressly so defined herein.

Disclosed herein are various devices, structures and methods for forming an optical interconnection between devices including both electronic integrated circuits (EICs) and photonic integrated circuits (PICs). In some embodiments, a hybrid transceiver may use a combination of EICs and PICs to transmit and receive optical signals between devices. In some embodiments, a first hybrid transceiver may bi-directionally communicate with a second hybrid transceiver using an optical interconnection.

As used herein electronic integrated circuits, or EICs, may refer to a wide variety of integrated circuits using electrical components. In some embodiments, EICs may include a combination of various electrical components such as transistors, resistors, inductors, and capacitors which in combination form an electronic circuit on a substrate. In some embodiments, EICs may include central processing units (CPUs), logic chips, memory such as static random-access memory (SRAM), dynamic random-access memory (DRAM), application processors (AP), auxiliary processing units (XPUs), graphical processing units (GPUs), artificial intelligence (AI) chips, high bandwidth memory (HBM) interfaces, and other application-specific integrated circuits (ASIC). In some embodiments, a combination of circuits may be present on a substrate. In some embodiments, EICs may be referred to in terms such as microchips, microcontrollers, silicon chips. As used herein, an XPU may refer to an auxiliary processing unit designed to perform specialized or dedicated processing optimized for conducting specific tasks more efficiently than a general processing unit such as a CPU., and may be also referred to as a data processing unit (DPU), infrastructure processing unit (IPU), function accelerator card (FAC), network attached processing unit (NAPU).

As used herein photonic integrated circuits, or PICs, may refer to a wide variety of integrated circuits using photonic components. In some embodiments, PICs may include a combination of various photonic components such as waveguides, optical filters, gratings, lenses, mirrors, and optical ring resonators. In some embodiments, PICs may include electrical components such as photodiodes, light emitting diodes, and laser diodes. In some embodiments, PICs may be referred to using terms such as integrated optical circuits, and planar light wave circuits.

As used herein substrates may refer to a variety of materials and structures, including wafers using silicon, wafers using silicon on an insulator (SOI) such as glass, wafers of other semiconductor materials such as germanium, as well as other semiconductor materials on an insulator. In some embodiments, a substrate may include an organic material, and may be referred to as an organic substrate. In some embodiments, the substrates may be referred to as wafers, dies, and chips alone or in combination. In some embodiments, a substrate for use in a PIC may be referred to a waveguide. Bonding substrates may be thus known in some embodiments as die-to-die (D2D) bonding, wafer-to-wafer bonding (W2W) or die-to-wafer bonding (D2W). In some embodiments, a packaged chip may contain multiple substrates, and may include PIC substrates, EIC substrates, or a combination of PIC substrates and EIC substrates. In some embodiments, circuits may be bonded directly facing each other, while in other embodiments a flip-chip bonding may be used. In some embodiments, interconnections may be made between substrates on a front or circuit side of the substrate. In other embodiments, interconnections may be made on a rear or back side of the substrate opposite from the circuit structure. In some embodiments, an interconnection may include through-silicon vias (TSVs) or other forms of through-chip vias where one or more substrates may be connected using a via traveling through an interposer such as another substrate or chip. In some embodiments, an interconnection may be formed using connections on a surface of a substrate, such as a pad, and may use additional materials between the pads such as solder to form an interconnection.

In some embodiments, bonding between substrates may involve bonding between metals, or metal-metal bonding. In some embodiments, bonding between substrates may involve bonding between dielectric materials, or dielectric-dielectric bonding. In some embodiments, bonding between substrates may involve both metal-metal and dielectric-dielectric bonding, known as hybrid bonding. A hybrid bonding technique may be used to provide additional connections between opposing surfaces, allowing both dielectric and conductive surfaces to bond, and may increase the mechanical strength of the resulting structure.

As used herein multiplexing may refer to a number of techniques for multiplexing optical signals. In some embodiments, multiplexing may refer to wavelength division multiplexing (WDM). In some embodiments, the multiplexing may refer to polarization-based multiplexing. In some embodiments, the multiplexing may refer to optical fiber mode based polarization. In some embodiments, multiplexing may be a combination of one or more of WDM, polarization, and fiber mode polarization.

As used herein, polarization may refer to both linear and circular polarization. Linear polarization may be referred to as S and P or transverse-magnetic (TM) and transverse-electric (TE) polarizations. Circular polarizations may be referred to as right-handed polarization (RCP) or left-handed polarization (RCP).

As used herein, conductors may refer to a variety of conductive materials, including which materials may be used alone or in combination with other materials such as in the form of an alloy. In some embodiments the conductor is copper (Cu). In some embodiments, copper (Cu) may be in the form of Cu (II), Cu (III) or other forms of copper, alone or in combination with additional elements, including cobalt (Co) and ruthenium (Ru). Such a listing of elements is not intended to be exhaustive, and in other embodiments, any known other type of conductive material may be used.

As used herein, a device stack or stack of devices may refer to a combination of memory and supporting circuit architecture, for example, chiplets and dies containing individual memory elements, supporting processing units, input output (I/O) circuitry, and other forms of integrated chips. As used herein, a chiplet may refer to an integrated circuit having a well-defined functionality, such as a microprocessor, a memory device, or other computational function; with a chiplet enabling a modular design with multiple chiplets able to be combined with a larger package, sharing a substrate or interposer to form a larger device. A core may refer to a single-unit of a multicore device where multiple devices form a larger device, with each device able to function independently to enable multiple streams of operations. In some embodiments, a core may take the form of a chiplet, or a chiplet may take the form of a core. However, in other embodiments, a chiplet may take the form of any other suitable integrated circuit.

As used herein, a bridge refers to a substrate, die, or other material having one or more electrically conductive pathways able to form connection between one or more semiconductor devices, as well as substrates, interposers, or other package structures. A bridge may include one or more electrically conductive traces forming a connection pathway along the bridge between one or more devices coupled to the bridge. An embedded bridge, as used herein, may refer to a bridge in a layer within a semiconductor package, and may be used interchangeably with bridge. An active bridge may refer to a bridge featuring additional features beyond connections, such as transistors, vias, and other circuit components.

Disclosed herein are various embodiments of systems, methods and devices using co-packaging of both EIC and PIC on a base substrate to form a hybrid device, which may be referred to as a hybrid transceiver. The hybrid transceiver may be formed in three-dimensions by stacking EIC and PIC dies on a support base. The support base may positioned on top of a supporting substrate, which may be a glass core substrate, a silicon substrate, or a substrate formed of any other suitable semiconductor material. The support base may include one or more redistribution layers (RDL) to transmit electrical signals and power between the support base and the EIC and PIC positioned upon the support base. A connecting element, also referred to as a bridge, may be used to couple EIC and PIC positioned on the support base. In some embodiments, the connecting element may be formed within the support base, while in other embodiments, the connecting element may be formed on top of the support base. In some embodiments, an additional EIC may be formed within the support base.

In some embodiments, the EIC may take the form of one or more compute devices positioned on top of the support base, the one or more compute devices including compute devices such as memory devices, processing devices such as XPUs, ASICs, and stacks including combinations such as HBMs. The PIC may, in some embodiments, form a transceiver for receiving and transmitting optical signals for the hybrid transceiver. The PIC may use a v-groove configuration to allow positioning optical communications fibers to the PIC. In some embodiments, the PIC may have one or more through-silicon vias (TSVs) allowing signals to travel through the PIC to devices positioned on either side of the PIC.

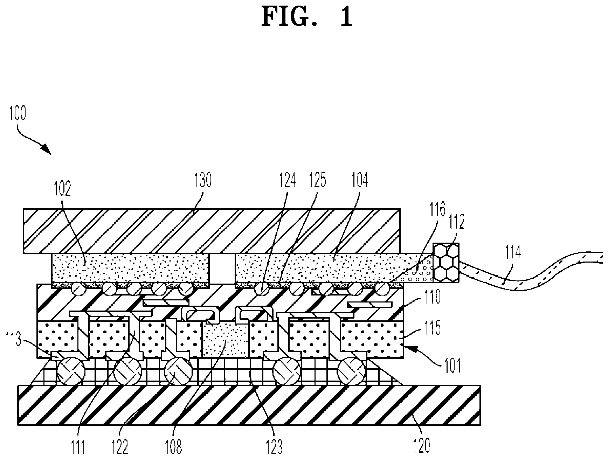

FIG. 1 discloses an exemplary embodiment of an architecture for a first hybrid transceiver 100 formed on a supporting substrate 120. In some embodiments, the supporting substrate 120 may comprise a glass substrate, a glass core substrate, a silicon substrate, or another other suitable substrate, while in other embodiments the supporting substrate 120 may take the form of an interposer, a circuit board, a card or other structure providing electrical signals and routing to the first hybrid transceiver 100. The first hybrid transceiver 100 may include a support base 101 positioned on the supporting substrate 120, the support base 101 providing support for a first compute device 102 and a PIC 104 and providing coupling of signals and power between the supporting substrate 120 and the first compute device 102 and the PIC 104.

In some embodiments, the first compute device 102 may be one or more of various forms of devices such as memory including DRAM, SRAM, and other forms of memory; a processor including CPU, XPU, GPUs; as well as additional suitable circuits, including ASICs, or combinations thereof. In some embodiments, the first compute device 102 may comprise a stack of one or more of the aforementioned devices (each also referred to herein as a "component device"). In some embodiments, the stack of component devices may include one or more memory devices, core devices, and combinations thereof. In some embodiments, a core device may include for example a processor, processing device, or other form of microcontroller to act as a controller. While the exemplary embodiment of FIG. 1 depicts only a first compute device 102, first hybrid transceiver 100 may include additional devices, for example with the first compute device 102 taking the form of an HBM device including multiple memory devices.

The support base 101 may have the first compute device 102 and the PIC 104 positioned thereon in a variety of ways and may include pads, bumps, microbumps, pillars, balls, ball grids, microball arrays, and other forms such as controlled-collapse chip connection (C4) bumps, alone or in combination. As used herein, a C4 bump refers to a form of solder bumps placed on pads on a top surface of a substrate prior to flipping the substrate to form a flip-chip. The positioning method may further include a dielectric material, which may include a material such as an adhesive, resin, or elastomer which may form a connection in addition to a conductive connection. In some embodiments, the combination of a conductive connection and a dielectric connection may form a hybrid bond.

The support base 101 may include an upper redistribution layer, also known as the upper RDL 110. The first compute device 102 and the PIC 104 may be positioned directly on the upper RDL 110, or one or more intermediate layers may be inserted between. The upper RDL 110 may provide one or more layers including a series of pads, bumps, vias, through-vias, traces, and other forms of connection for redistributing electrical signals on the top of the support base 101. The upper RDL 110 may electrically couple to the first compute device 102 and the PIC 104, as well as to one or more pillars 111 within the support base 101. The one or more pillars 111 within the support base 101 may electrically couple the upper RDL 110 to one or more connecting elements 108 positioned on or within the support base 101, as well as electrically couple the upper RDL 110 to a backside redistribution layer or backside RDL 113 on the bottom of the support base 101 and, in some embodiments, may take the form of one or more through-vias. The backside RDL 113 may in turn provide one or more layers including a series of pads, bumps, vias, through-vias, traces, and other forms of connection for redistributing signals from electrical connections from the supporting substrate 120 to the one or more pillars 111, the one or more connecting elements 108, the first compute device 102, and the PIC 104.

The interconnection between the support base 101 and the supporting substrate 120 may include conductive materials forming substrate interconnections 122 to electrically couple the support base 101 to the supporting substrate 120 including pads, bumps, microbumps, pillars, balls, and other forms such as C4 bumps, alone or in combination. In some embodiments, a bonding layer 123 between the support base 101 and the supporting substrate 120 may include a dielectric material or an adhesive, like underfill material, to provide additional strength and connection between the support base 101 and the supporting substrate 120. In some embodiments, the interconnection may provide a metallic bonding between the support base 101 and the supporting substrate 120, a dielectric bonding between the support base 101 and the supporting substrate 120, or a hybrid bonding between the support base 101 and the supporting substrate 120. In some embodiments, the interconnection may bond directly with the backside RDL 113, while in other embodiments, intermediate layers may between the interconnection and the backside RDL 113.

The one or more pillars 111, the upper RDL 110, the backside RDL 113, and the one or more connecting elements 108 may be separated by a molding layer 115. The molding layer 115 may provide thermal, electrical, and mechanical protection for the various components in and on the support base 101. The molding layer 115 may be formed from a dielectric material such as silicon dioxide, resins, adhesives, and epoxies, alone or in combination, and may in some embodiments include an epoxy molding compound (EMC).

In the example embodiment of FIG. 1, the first compute device 102 and the PIC 104 may be positioned upon the upper RDL 110 using one or more electrically conductive connections 124 and one or more dielectric bonds 125. The one or more electrically conductive connections 124 may include pads, bumps, microbumps, pillars, balls, ball grids, microball arrays, and other forms such as C4 bumps, alone or in combination. The one or more dielectric bonds 125 may include a dielectric material or adhesive between the first compute device 102 or the PIC 104 and the upper RDL 110, such as an epoxy, a resin, or other suitable material. In some embodiments, the one or more dielectric bonds 125 may be formed using an underfill technique and inserted between the first compute device 102 or the PIC 104 and the upper RDL 110 and around the one or more electrically conductive connections 124. In some embodiments, the one or more electrically conductive connections 124 and the one or more dielectric bonds 125 may combine to form a hybrid bond between the first compute device 102 or the PIC 104 and the support base 101.

In some embodiments, the support base 101 may also include one or more connecting elements 108 embedded within. The one or more connecting elements 108 may, in some embodiments, be positioned on directly to the backside RDL 113, while in other embodiments, an attach film (not shown) may be located between the backside RDL 113 and the one or more connecting elements 108. In some embodiments, the attach film may be formed from an adhesive material such as a resin or epoxy, a metal layer, a dielectric material, or any other suitable material to form one or more layers to allow one or more connecting elements 108 to position on the backside RDL 113. In some embodiments, one or more connecting elements 108 may be a single bridge element, while in other embodiments, one or more connecting elements 108 may be include additional bridges, an EIC, a die, a PIC, or some other suitable element for forming a connection between two circuits, or in a combination thereof. one or more connecting elements 108 may, in some embodiments, be coupled directly to the first compute device 102 or the PIC 104, while in other embodiments the upper RDL 110 couples to the one or more connecting elements 108 to one or both of the first compute device 102 and the PIC 104. The one or more connecting elements 108 may, in some embodiments, act as a bridging element to provide a communicative connection coupling the first compute device 102 and the PIC 104.

The PIC 104 may take the form of one or more layers of optical components provided upon an optical substrate, for example glass, polymer, and silicon oxide. In some embodiments, one or more buried oxide layers (or BOX layers) may be formed upon an optical substrate and contain various photonic device components, which may be referred to as the active layer. The PIC 104 may, in some embodiments, include components for modulating the optical signals such as micro-ring resonators, serializers, phase shifters, couplers, lenses, polarizers, gratings, anti-reflection coatings, filters, index matching coatings, mirrors, delay lines, and a variety of other photonic elements both passive and active. An optical signal may, in some embodiments, be generated from an external source and provided to the PIC 104, while in other embodiments the PIC 104 may include a light generation source such as a laser comb source such as a four-wave-mixing-based frequency comb, a Kerr frequency comb, or any other suitable technique for generating a comb signal. As used herein, a comb signal refers to an optical signal having a plurality of wavelengths separated into discrete spectra. The photonic components of the PIC 104 may modulate, redirect, combine, separate and otherwise modify an optical signal within the PIC 104. In some embodiments, the PIC 104 may include one or more layers of electrical components, and in some embodiments may provide a bridge connecting the first compute device 102 and an EIC. In some embodiments, the PIC 104 may include additional electronic circuitry, such as a logic structure for routing electrical signals from the PIC 104 to the rest of the first hybrid transceiver 100.

In some embodiments, the first compute device 102 may provide the driving electronics for the PIC 104, including heater control circuits, heater drivers, modulator drivers, and serializers to modify the optical signal within the PIC 104. For example, if the PIC 104 includes one or more micro-ring resonators, heaters may be integrated with the one or more micro-ring resonators to provide control over the resonance frequency of the one or more micro-ring resonators by altering the physical characteristics of the one or more micro-ring resonators. While portions of the heaters may be formed within the PIC 104, the electronics controlling and regulating the heaters are within the first compute device 102 separate from the PIC 104. Furthermore, the PIC 104 may include one or more photodetectors to receive an optical signal, which may be transmitted to the first compute device 102 for further signal processing, including amplification, analog to digital conversion, rectification, or any other suitable signal processing techniques. In some embodiments, some or all of the driving electronics for the PIC 104 may be transferred from the first compute device 102 to another device, such as an additional EIC which may connect directly to the support base 101, or via the supporting substrate 120.

A first optical connection 114 may connect to the PIC 104. In some embodiments, the first optical connection 114 may be a fiber optic, an optical connector, a pluggable optical connector, a plug connector, as well as combinations thereof and various arrays thereof. In some embodiments, the first optical connection 114 may include a single fiber with a single core, while in other embodiments the first optical connection may include one or more cores in one or more fibers. In some embodiments, the first optical connection 114 may be unidirectional fiber, allowing only transmitting or receiving, while in other embodiments, the first optical connection 114 may be a bi-directional fiber. In some embodiments, additional optical elements may be placed between the first optical connection 114 and the PIC 104, such as polarizers, gratings, anti-reflection coatings, filters, index matching coatings, lenses, and any other suitable optical components, alone or in a combination thereof. In some embodiments, the first optical connection 114 may allow the first hybrid transceiver 100 to transmit optical signals, to receive optical signals, or both receive and transmit optical signals.

In some embodiments, the PIC 104 may couple to a plurality of optical connections, including a receiving optical connection to receive incoming optical signals, and a transmitting optical connection to transmit outgoing optical signals. In some embodiments, the plurality of optical connections may include one or more separated optical connections, the separated optical connections corresponding to one or more multiplexing methods, for example, wavelength based multiplexing, fiber mode based multiplexing, polarization based multiplexing, and combinations thereof. In some embodiments, the first optical connection 114 may provide an optical coupling for optical signals to one or more additional systems, including additional computational systems, networks, remote computers, and any other suitable optical devices.

The first optical connection 114 may optically couple to the PIC 104 using one or more optical ports 116. In some embodiments, the one or more optical ports 116 may be v-grooves coupled to one or more waveguides within the PIC 104. As used herein, v-grooves may refer to V-shaped grooves formed within the active layer of a PIC 104, where the v-groove is sized to match a corresponding fiber on the first optical connection 114, which the v-groove is able to receive and transmit optical signals from the first optical connection 114 to the waveguides within the PIC 104. In some embodiments, an optical coupler 112 may be used to connect the first optical connection 114 to the one or more optical ports 116. In some embodiments, the optical coupler 112 may be a plug connector allowing the first optical connection 114 to be removably coupled to the one or more optical ports 116. In other embodiments, the optical coupler 112 may take the form of a pressurized component to secure the first optical connection 114 to the one or more optical ports 116, as well as take the form of an adhesive coupling the one or more optical ports 116 and the first optical connection 114, while in further embodiments, a combination thereof may be used.

In some embodiments, the optical coupler 112 may couple multiple fibers within the first optical connection 114 such that each fiber of the first optical connection 114 may couple directly with a corresponding optical port of the one or more optical ports 116. In some embodiments, the optical coupler 112 may be a fiber attach unit (FAU).

A dummy layer 130 may be positioned on top of the first compute device 102 and the PIC 104. The dummy layer 130 may be formed of a thermally conductive material, such as silicon, able to provide a thermal pathway and potentially dissipating heat. In some embodiments, the dummy layer 130 may be formed directly over the first compute device 102 and the PIC 104, while in other embodiments one or more intermediate layers may be between the first compute device 102 and the PIC 104 to bond the dummy layer 130 to the rest of the first hybrid transceiver 100. In some embodiments, the dummy layer 130 may be substantially uniform in thickness, while in other embodiments the dummy layer 130 may have an overhang recess to fit a component such as an EIC or additional compute devices. In some embodiments, the dummy layer 130 may expose a portion of the PIC 104 and the one or more optical ports 116. In some embodiments, the dummy layer 130 may extend only partially across the width of the support base 101, such that a portion of PIC 104 is exposed. In some embodiments, the dummy layer 130 may extend across the width of the support base 101, with the PIC 104 extending beyond both the dummy layer 130 and the support base 101 to allow coupling to the first optical connection 114.

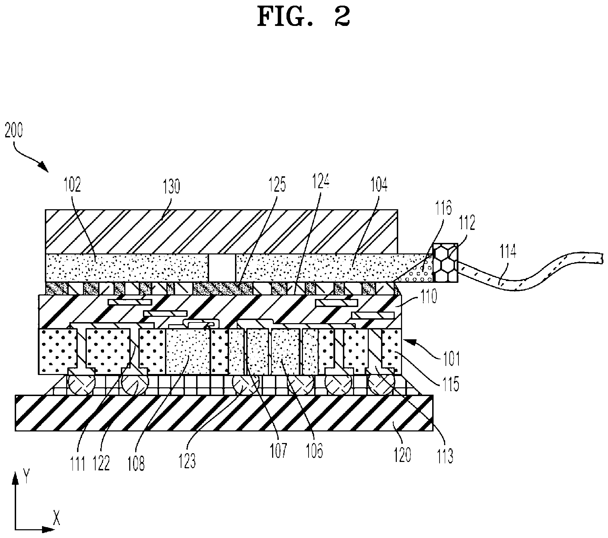

FIG. 2 depicts an example of the second hybrid transceiver 200, the second hybrid transceiver 200 differing from the first hybrid transceiver 100 of FIG. 1 by including an EIC 106 embedded within the support base 101. The EIC 106 may be electrically coupled using the upper RDL 110 to the PIC 104 and the first compute device 102. In some embodiments, the EIC 106 may provide the control electronics for the PIC 104, providing and receiving electrical signals coupled to the active components of the PIC 104. For example, the EIC 106 may include circuitry to receive signals from a photodetector optically coupled with the PIC 104 receiving an optical signal, which the EIC 106 may in full or in part convert to an electrical signal. The EIC 106 may also provide control signals to elements such as heaters on the PIC 104 to provide optical switching. In some embodiments, the EIC 106 may be electrically coupled directly to the backside RDL 113 and the upper RDL 110, while in other embodiments intermediate layers may be inserted between one or both of the backside RDL 113 and the upper RDL 110. In some embodiments, the EIC 106 may include one or more TSVs 107. The one or more TSVs 107 may provide a pathway for signals and power to travel from the supporting substrate 120 to the first compute device 102 and the PIC 104 using the backside RDL 113 and the upper RDL 110. The one or more TSVs 107 may provide a boost in power delivery efficiency to the first compute device 102 and the PIC 104 in some embodiments.

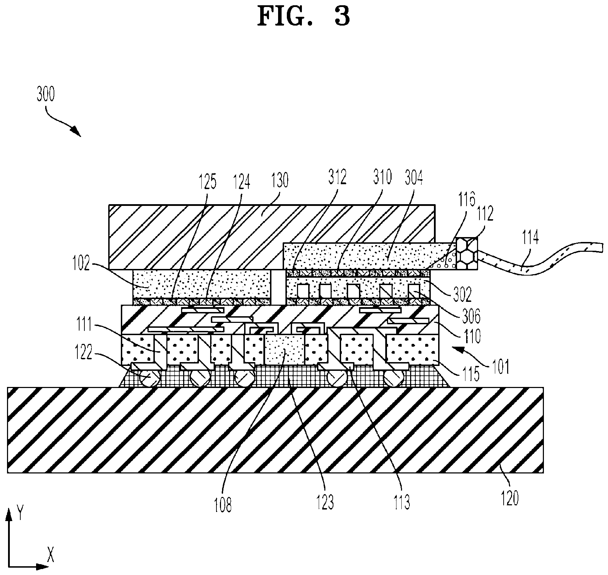

FIG. 3 depicts a third hybrid transceiver 300, the third hybrid transceiver 300, differing from the first hybrid transceiver 100 of FIG. 1 by including an upper PIC 304 positioned on an upper EIC 302. The dummy layer 130 is formed with a recess to fit the upper EIC 302 and the upper PIC 304. The upper EIC 302 may function similar to the EIC 106 to control and receive signals from the upper PIC 304. The upper PIC 304 may be similar to the PIC 104, but with the upper PIC 304 having the upper EIC 302 between the upper PIC 304 and the support base 101. The upper EIC 302 may include one or more vias 306 to electrically couple the upper PIC 304 to the support base 101. The upper PIC 304 may be coupled to the upper EIC 302 using one or more upper electrically conductive connections 310 and one or more upper dielectric bonds 312. The one or more upper electrically conductive connections 310 may include pads, bumps, microbumps, pillars, balls, ball grids, microball arrays, and other forms such as C4 bumps, alone or in combination. The one or more upper dielectric bonds 312 may include a dielectric material or adhesive between the upper EIC 302 and the upper PIC 304, such as an epoxy, a resin, or other suitable material. In some embodiments, the one or more upper dielectric bonds 312 may be formed using an underfill technique and inserted between the upper EIC 302 and the upper PIC 304 and around the upper electrically conductive connections 310. In some embodiments, the one or more electrically conductive connections 124 and the one or more upper dielectric bonds 312 may combine to form a hybrid bond between the upper EIC 302 and the upper PIC 304.

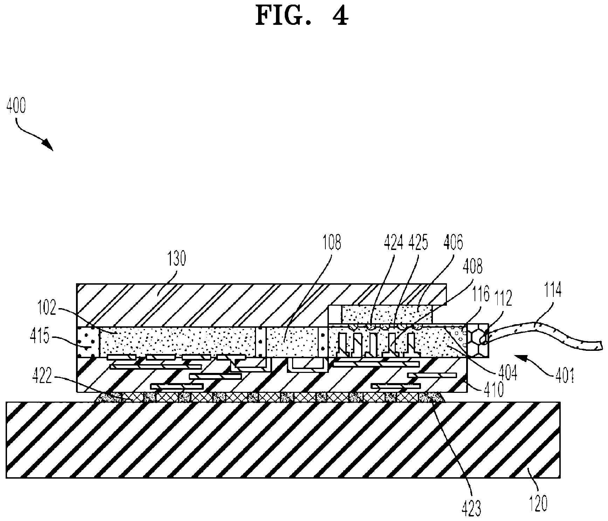

FIG. 4 depicts a fourth hybrid transceiver 400, the fourth hybrid transceiver 400 differing from the first hybrid transceiver 100 of FIG. 1 by using a flat layout with a flat RDL 410 electrically coupling the first compute device 102, an inverted PIC 404, and the one or more connecting elements 108. In FIG. 4, a single redistribution layer in the form of the flat RDL 410 may be used to electrically couple the one or more connecting elements 108. The PIC used in the fourth hybrid transceiver 400 may be the inverted PIC 404, the inverted PIC 404 being similar to the PIC 104 but having its orientation flipped such that the one or more optical ports 116 are upside-down relative to the PIC 104. A positioned EIC 406 is coupled to the inverted PIC 404. As the inverted PIC 404 is flipped relative to the PIC 104, one or more flipped vias 408 may also be flipped relative to the one or more vias 306 of FIG. 3. The one or more flipped vias 408 may electrically couple the active layers of the inverted PIC 404 to the positioned EIC 406 such that the positioned EIC 406 may provide the driver functions for the inverted PIC 404. The one or more flipped vias 408 may also form a connection to electrically couple the positioned EIC 406 to the flat RDL 410 and provide additional electrical coupling to the one or more connecting elements 108 and the first compute device 102. A flat molding layer 415 may provide thermal, electrical, and mechanical protection for the various components in and on the fourth hybrid transceiver 400. The flat molding layer 415 may be formed from a dielectric material such as silicon dioxide, resins, adhesives, and epoxies, alone or in combination, and may in some embodiments include an EMC. The dummy layer 130 may include a recess to fit the positioned EIC 406 and the inverted PIC 404. The flat RDL 410, the flat molding layer 415, the first compute device 102, the one or more connecting elements 108, and the inverted PIC 404 may be referred to as the flat base 401.

The positioned EIC 406 may be positioned on the inverted PIC 404 using one or more positioned conductive connections 424 and one or more positioned dielectric bonds 425. The one or more positioned conductive connections 424 may include pads, bumps, microbumps, pillars, balls, ball grids, microball arrays, and other forms such as C4 bumps, alone or in combination. The one or more positioned dielectric bonds 425 may include a dielectric material or adhesive between positioned conductive connections 424, such as an epoxy, a resin, or other suitable material. In some embodiments, the one or more positioned dielectric bonds 425. may be formed using an underfill technique and inserted between positioned conductive connections 424 and around the one or more positioned conductive connections 424. In some embodiments, the one or more positioned conductive connections 424 and the one or more positioned dielectric bonds 425 may combine to form a hybrid bond between the inverted PIC 404 and the positioned EIC 406.

The interconnection between the fourth hybrid transceiver 400 and the supporting substrate 120 may include electrically conductive materials forming transceiver interconnections 422 to electrically couple the fourth hybrid transceiver 400 to the supporting substrate 120 including pads, bumps, microbumps, pillars, balls, and other forms such as C4 bumps, alone or in combination. In some embodiments, a transceiver bonding layer 423 between the fourth hybrid transceiver 400 and the supporting substrate 120 may include a dielectric material or an adhesive, like underfill material, to provide additional strength and connection between the fourth hybrid transceiver 400 and the supporting substrate 120. In some embodiments, the interconnection may provide a metallic bonding between the fourth hybrid transceiver 400 and the supporting substrate 120, a dielectric bonding between the fourth hybrid transceiver 400 and the supporting substrate 120, or in some embodiments a hybrid bonding between the fourth hybrid transceiver 400 and the supporting substrate 120. In some embodiments, the interconnection may bond directly with the flat RDL 410, while in other embodiments, intermediate layers may between the interconnection and the flat RDL 410.

The fourth hybrid transceiver 400 differs from the transceivers introduced in FIGS. 1-3 by exchanging vertical and horizontal space. The fourth hybrid transceiver 400 is able to use a single RDL in the form of the flat RDL 410 by moving the one or more connecting elements 108 between the first compute device 102 and the inverted PIC 404. In contrast, the transceivers introduced in FIGS. 1-3 place the one or more connecting elements 108 within the support base 101, and are able to reduce the horizontal footprint in comparison to the fourth hybrid transceiver 400.

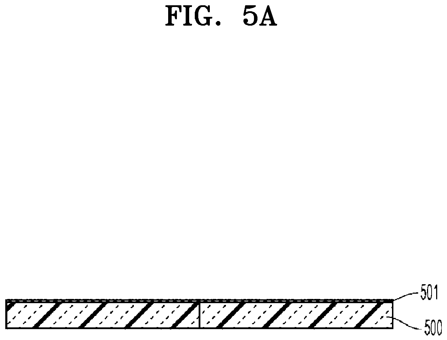

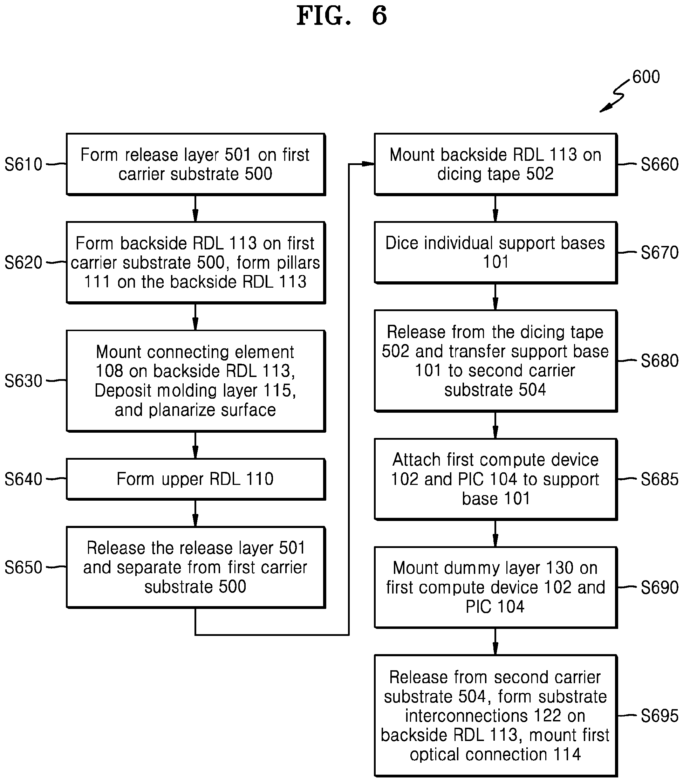

FIGS. 5A-5K depict an illustrative embodiment of a process of forming a device package architecture such as the first hybrid transceiver 100, or any other device package architectures shown herein. FIG. 6 depicts an example embodiment of a process 600 for forming a device package assembly corresponding to the illustrative embodiment of FIGS. 5A-5K.

FIG. 5A depicts S610 in the process of FIG. 6 where formation of the support base 101 begins on a first carrier substrate 500. The first carrier substrate 500 may be any suitable substrate, such as a glass substrate or a silicon substrate. In some embodiments, a release layer 501 may be formed on the first carrier substrate 500. The release layer 501 may comprise a material such as a polymer, wax, epoxy, or resin which acts as a sacrificial layer and may be cleanly removed from the first carrier substrate 500 and the backside RDL 113.

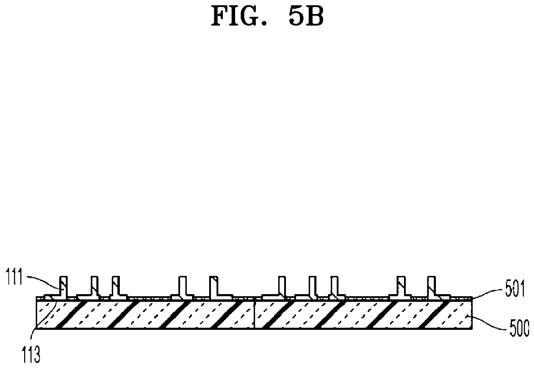

FIG. 5B depicts S620 in the process of FIG. 6 where the backside RDL 113 and the one or more pillars 111 are formed on the first carrier substrate 500. The backside RDL 113 may be formed using complementary metal-oxide-semiconductor (CMOS) processes, such as depositing, lithography, etching, including both wet etch and dry etch, and passivation directly on the first carrier substrate 500. In some embodiments, the backside RDL 113 may be formed on a separate substrate and transferred to the first carrier substrate 500. In addition, S620 depicts the formation of one or more pillars 111 on the backside RDL 113. The one or more pillars 111 may comprise a conductive material, including metals such as copper, as well as other known conductive materials, such as doped carbon. The one or more pillars 111 are bonded to the backside RDL 113 and may form an interconnection for the upper RDL 110 added later. In some embodiments, the one or more pillars 111 may be bonded using metal diffusion bonding between a metallic material forming the one or more pillars 111 and corresponding metal materials within the backside RDL 113.

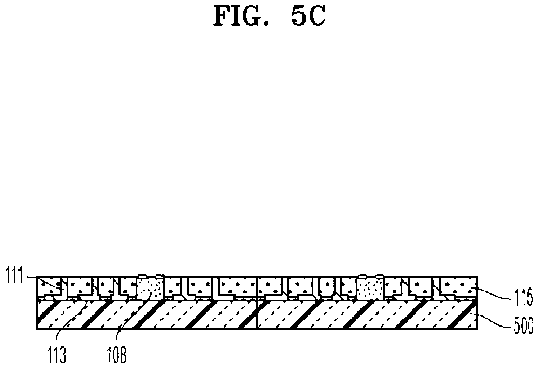

FIG. 5C depicts S630 in the process of FIG. 6 where the connecting element 108 is positioned on the backside RDL 113. In some embodiments, the one or more connecting elements 108 may be positioned directly on the backside RDL 113, while in other embodiments, a die attach film may be placed prior to positioning the one or more connecting elements 108. A die attach film may, for example, include one or more dielectric materials to enable coupling to dielectric materials within the backside RDL 113. The one or more connecting elements 108 may take the form of an embedded circuit forming a coupling between two or more devices, such as the first compute device 102 and the PIC 104. The one or more connecting elements 108 may include one or more conductive pathways, such as traces or wiring, in a dielectric layer. For example, the one or more connecting elements 108 may be formed using a substrate or die having a series of traces thereupon. In some embodiments, the one or more connecting elements 108 may include additional electronic components to provide routing or switching of signals within the one or more connecting elements 108. In some embodiments, additional features beyond connections, such as transistors, vias, and other circuit components may be incorporated into the one or more connecting elements 108.

Furthermore, after the one or more connecting elements 108 are positioned, the molding layer 115 may be deposited over the pillars 111, the backside RDL 113 and the one or more connecting elements 108 and then planarized. The molding layer 115 may be formed from a dielectric material such as silicon dioxide, resins, adhesives, and epoxies, alone or in combination, and may in some embodiments include EMC. After the deposition of the molding layer 115, the pillars 111, the backside RDL 113, the molding layer 115 and the one or more connecting elements 108 may be subject to a process to smooth and or planarize the surface, the process including one or more grinding, polishing, and smoothing processes, including chemical mechanical polishing (CMP).

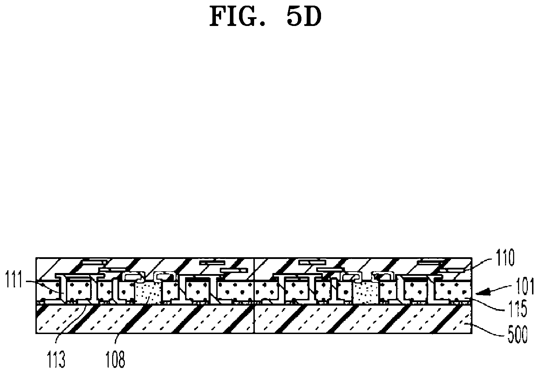

FIG. 5D depicts S640 in the process of FIG. 6 where the upper RDL 110 is formed over the one or more connecting elements 108, the molding layer 115 and the pillars 111, also known as the embedded layers. In some embodiments, the upper RDL 110 may be formed using CMOS processes, such as depositing, lithography, etching, and passivation directly on the first carrier substrate 500. In some embodiments, the upper RDL 110 may be formed on a separate substrate and transferred to the first carrier substrate 500. The upper RDL 110 may include one or more layers including a series of pads, bumps, vias, through-vias, traces, and other forms of connection for redistributing signals from the embedded layers to an appropriate location on the top of upper RDL 110. The upper RDL 110 may also include one or more dielectric layers to provide insulation and support for the conductive elements within. In some embodiments, a portion of the molding layer 115 may be exposed to provide a suitable dielectric surface for forming hybrid bonds. The formation of the upper RDL 110 with the backside RDL 113, and the components between thus may be referred to as the support base 101.

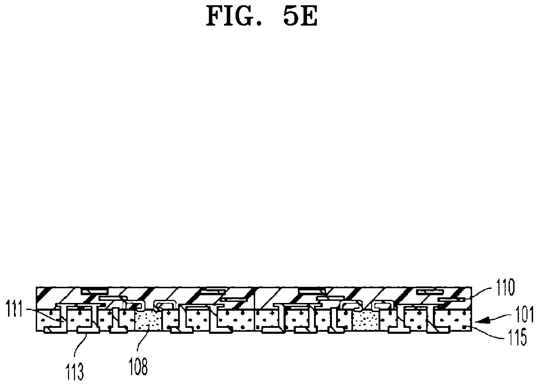

FIG. 5E depicts S650 in the process of FIG. 6 where the support base 101 is removed from the first carrier substrate 500. The first carrier substrate 500 may be released, for example, by using one or more of layer release, chemical release, thermal release, or photo release techniques to release an adhesive layer such as release layer 501 coupling the first carrier substrate 500 to the first hybrid transceiver 100. For example, in some embodiments a chemical release technique may use a solvent to dissolve the adhesive directly, while a thermal release technique may apply heat to the carrier wafer to melt the adhesive, and a photo release technique may use lasers to directly apply energy to the adhesive layer to reduce the adhesive strength.

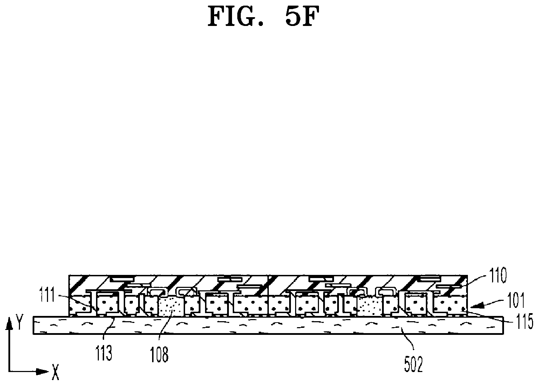

FIG. 5F depicts S660 in the process of FIG. 6 where the support base 101 is positioned on a dicing tape 502. The dicing tape 502 is a CMOS compatible material including an adhesive layer allowing the support base 101 to couple to the dicing tape 502.

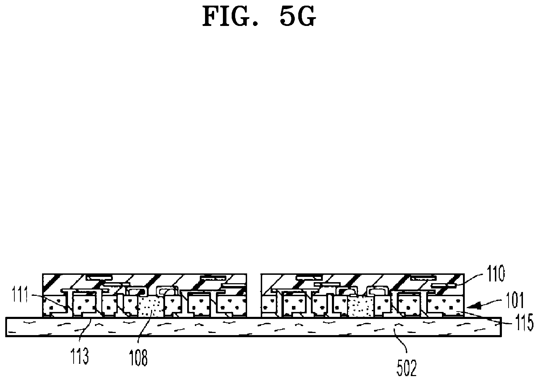

FIG. 5G depicts S670 in the process of FIG. 6 where a dicing step separates individual support bases. The dicing may be performed using a scribe step compatible with the dicing tape 502, such as mechanical separation using a blade or shear process, as well as other techniques such as using thermal or photonic energy.

Within the process depicted in FIG. 5B-5E, multiple of the support base 101 may be formed together on the first carrier substrate 500. FIG. 5F and FIG. 5G depict the separation into separate elements. In some embodiments, each of the support base 101 may be formed separately rather than on a shared substrate.

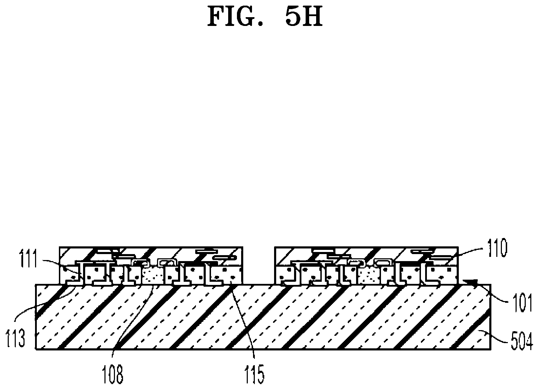

FIG. 5H depicts S680 in the process of FIG. 6 where the support base 101, after being separated at FIG. 5G into separate units, are positioned on a second carrier substrate 504. The second carrier substrate 504 may be any suitable substrate, such as a glass substrate or a silicon substrate. In some embodiments, a release layer (not shown) may be formed on the second carrier substrate 504. The release layer may comprise a material such as a polymer, wax, epoxy, or resin which acts as a sacrificial layer and may be cleanly removed from the second carrier substrate 504 and the backside RDL 113.

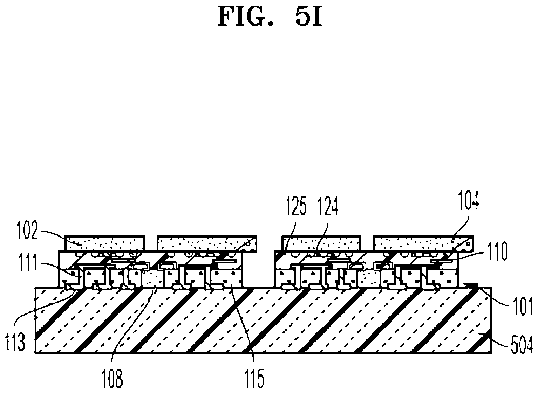

FIG. 5I depicts S685 in the process of FIG. 6 where the first compute device 102 and the PIC 104 are positioned upon the support base 101. The first compute device 102 and the PIC 104 may be positioned upon the upper RDL 110 using one or more electrically conductive connections 124 and one or more dielectric bonds 125. The one or more electrically conductive connections 124 may include pads, bumps, microbumps, pillars, balls, ball grids, microball arrays, and other forms such as C4 bumps, alone or in combination. The one or more dielectric bonds 125 may include a dielectric material or adhesive between the first compute device 102 or the PIC 104 and the upper RDL 110, such as an epoxy, a resin, or other suitable material. In some embodiments, the one or more dielectric bonds 125 may be formed using an underfill technique and inserted between the first compute device 102 or the PIC 104 and the upper RDL 110 and around the one or more electrically conductive connections 124. In some embodiments, the one or more electrically conductive connections 124 and the one or more dielectric bonds 125 may combine to form a hybrid bond between the first compute device 102 or the PIC 104 and the support base 101.

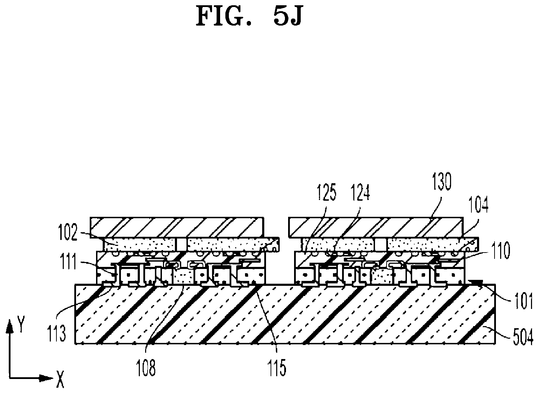

FIG. 5J depicts S690 in the process of FIG. 6 where the dummy layer 130 is positioned on the first hybrid transceiver 100. The dummy layer 130 may be formed of a thermally conductive material, such as silicon, able to provide a thermal pathway and potentially dissipating heat. In some embodiments, the dummy layer 130 may be formed directly over the first compute device 102 and the PIC 104, while in other embodiments one or more intermediate layers may be between the first compute device 102 and the PIC 104 to bond the dummy layer 130 to the rest of the first hybrid transceiver 100. In some embodiments, the dummy layer 130 may be formed separately and positioned upon the first compute device 102 and the PIC 104, while in other embodiments, the dummy layer 130 may be formed directly on top of the first compute device 102 and the PIC 104 using a process such as deposition.

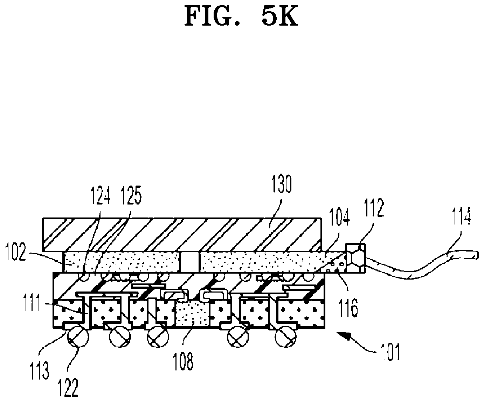

FIG. 5K depicts S695 in the process of FIG. 6 where the first hybrid transceiver 100 is released from the second carrier substrate 504. Additionally, along with releasing the first hybrid transceiver 100 from the second carrier substrate 504, the substrate interconnections 122 are formed on the support base 101, and the first optical connection 114 may be positioned.

The second carrier substrate 504 may be released, for example, by using one or more of layer release, chemical release, thermal release, or photo release techniques to release an adhesive layer coupling the second carrier substrate 504 to the first hybrid transceiver 100. For example, in some embodiments a chemical release technique may use a solvent to dissolve the adhesive directly, while a thermal release technique may apply heat to the carrier wafer to melt the adhesive, and a photo release technique may use lasers to directly apply energy to the adhesive layer to reduce the adhesive strength.

The substrate interconnections 122 includes conductive elements such as pads, bumps, microbumps, pillars, balls, ball grids, microball arrays, and other forms such as C4 bumps, alone or in combination. In some embodiments, the substrate interconnections 122 may be formed separately and be positioned as a unit to the support base 101. In other embodiments, one or more of the substrate interconnections 122 may be formed directly on the backside RDL 113, such as by depositing a soldering material. The substrate interconnections 122 may further be used to electrically couple the first hybrid transceiver 100 to the supporting substrate 120. In some embodiments, the aforementioned bonding layer 123 between the support base 101 and the supporting substrate 120 may include a dielectric material or an adhesive, like underfill material, to provide additional strength and connection between the support base 101 and the supporting substrate 120. The supporting substrate 120 may be formed of any suitable material, and may include glass, silicon, as well as organic materials such as polymers.

The first optical connection 114 may optically couple to the PIC 104 using one or more optical ports 116. In some embodiments, the one or more optical ports 116 may be v-grooves coupled to one or more waveguides within the PIC 104. In some embodiments, an optical coupler 112 may be used to connect the first optical connection 114 to the one or more optical ports 116. In some embodiments, the optical coupler 112 may be a plug connector allowing the first optical connection 114 to be removably coupled to the one or more optical ports 116. In other embodiments, the optical coupler 112 may take the form of a pressurized component to secure the first optical connection 114 to the one or more optical ports 116, as well as take the form of an adhesive coupling the one or more optical ports 116 and the first optical connection 114, while in further embodiments, a combination thereof may be used.

In some embodiments, the optical coupler 112 may couple multiple fibers within the first optical connection 114 such that each fiber of the first optical connection 114 may couple directly with a corresponding optical port of the one or more optical ports 116. In some embodiments, the optical coupler 112 may be a FAU.

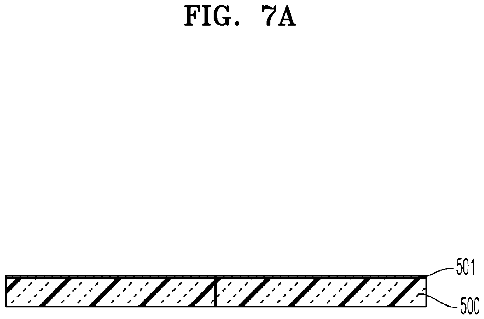

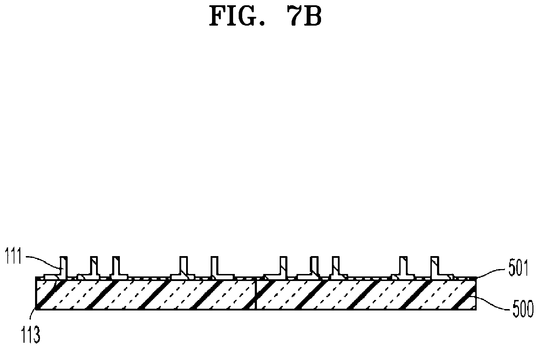

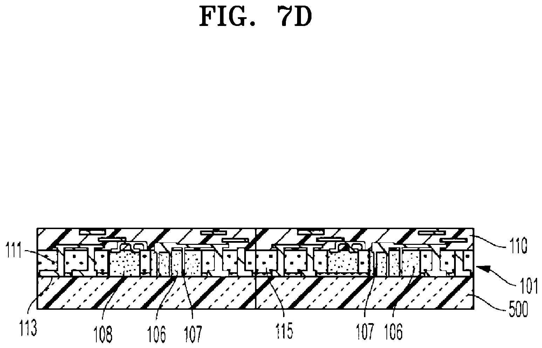

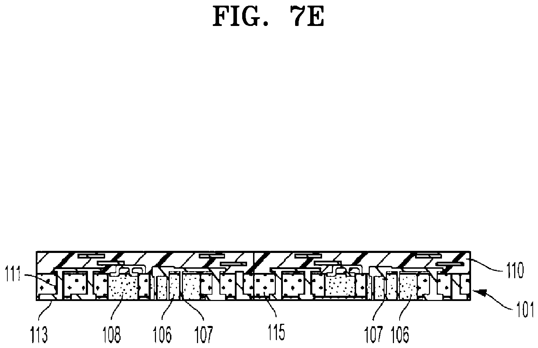

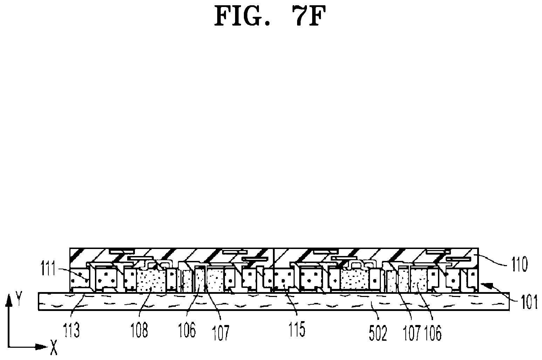

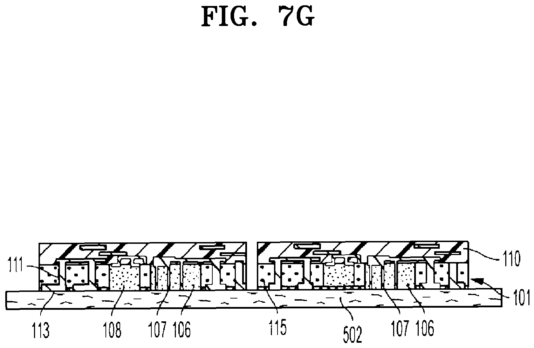

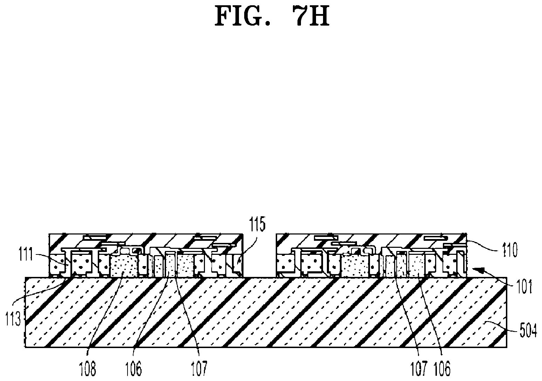

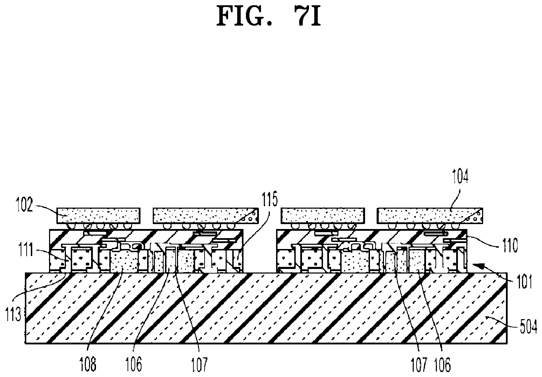

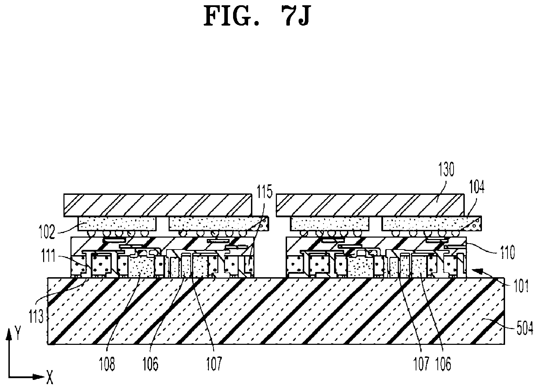

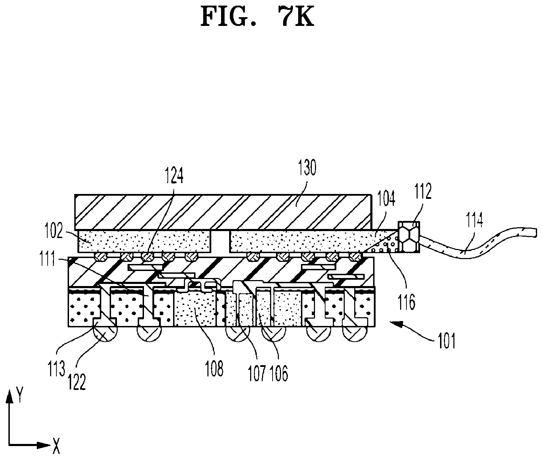

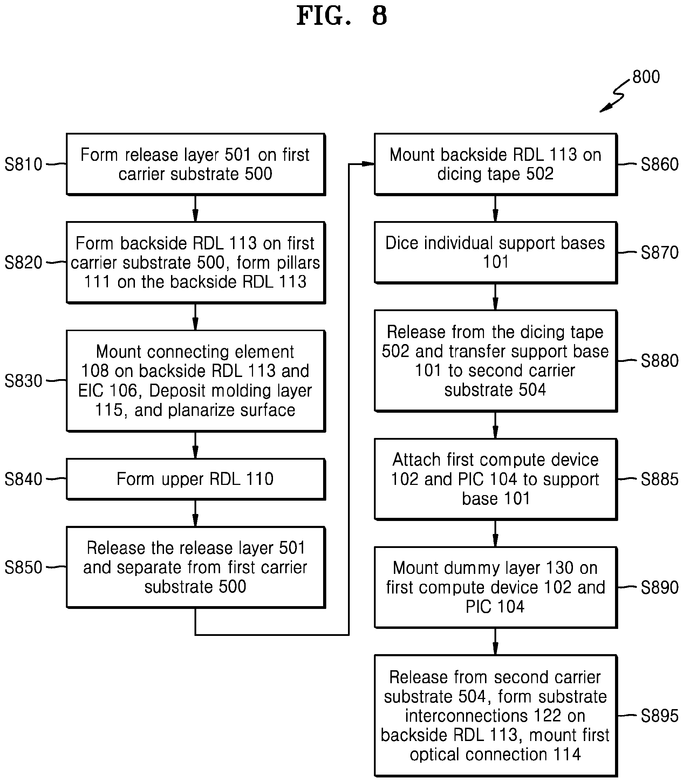

FIGS. 7A-7K depict an illustrative embodiment of a process of forming a device package architecture such as the second hybrid transceiver 200, or any other device package architectures shown herein. FIG. 8 depicts an example embodiment of a process 800 for forming a device package assembly corresponding to the illustrative embodiment of FIGS. 7A-7K.

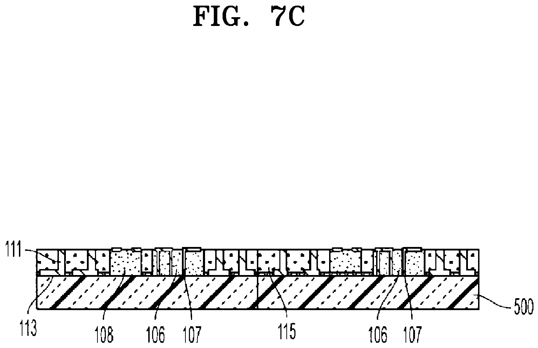

The second hybrid transceiver 200 differs primarily from the first hybrid transceiver by the support base 101 including the EIC 106 embedded within the support base 101. Thus, as shown in FIG. 7C, the EIC 106 may be positioned along with the one or more connecting elements 108.

The EIC 106 may, in some embodiments, be positioned on directly to the backside RDL 113, while in other embodiments, an attach film may be located between the backside RDL 113 and the EIC 106. In some embodiments, the attach film may be formed from an adhesive material such as a resin or epoxy, a metal layer, a dielectric material, or any other suitable material to form one or more layers to allow the EIC 106 to be positioned on the backside RDL 113. In some embodiments, EIC 106 provide the control electronics for the PIC 104, providing and receiving electrical signals coupled to the active components of the PIC 104. For example, the EIC 106 may include circuitry to receive signals from a photodetector coupled with the PIC 104 receiving an optical signal, which the EIC 106 may in full or in part convert to an electrical signal. The EIC 106 may also provide control signals to elements such as heaters on the PIC 104 to provide optical switching. In some embodiments, the EIC 106 may be coupled directly to the backside RDL 113 and the upper RDL 110, while in other embodiments intermediate layers may be inserted between one or both of the backside RDL 113 and the upper RDL 110. In some embodiments, the EIC 106 may include one or more TSVs 107, which may electrically couple the backside RDL 113 to the upper RDL 110. In some embodiments, the one or more TSVs 107 may provide electric power to the first compute device 102.

The process 800 as depicted in FIGS. 7A-7K may otherwise be substantially the same as in process 600 as depicted in FIGS. 5A-5K.

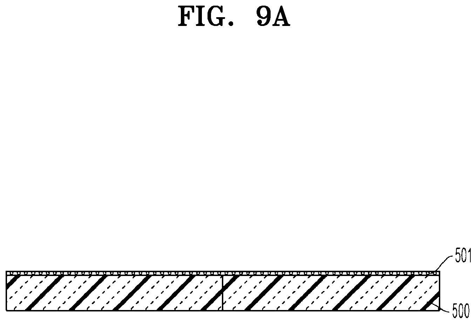

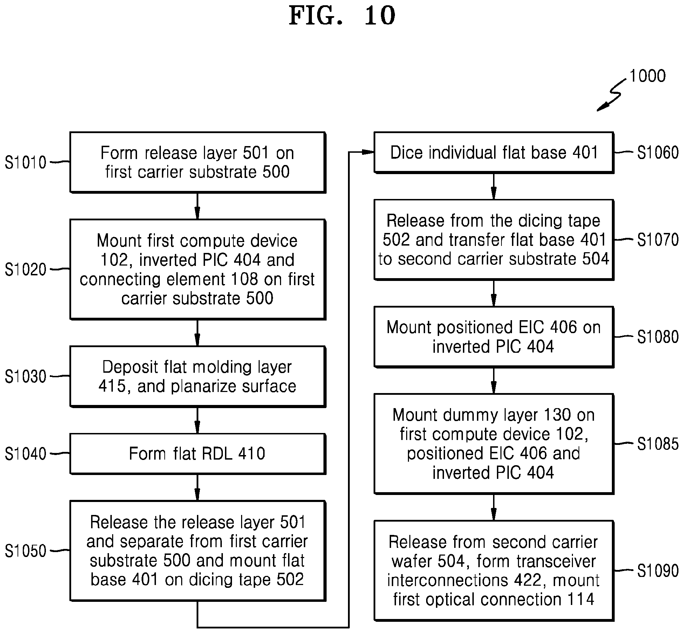

FIGS. 9A-9J depict an illustrative embodiment of a process of forming a device package architecture such as the fourth hybrid transceiver 400, or any other device package architectures shown herein. FIG. 10 depicts an example embodiment of a process 1000 for forming a device package assembly corresponding to the illustrative embodiment of FIGS. 9A-9J.

FIG. 9A depicts S1010 in the process of FIG. 10 where formation of the fourth hybrid transceiver 400 begins on the first carrier substrate 500. The first carrier substrate 500 may be any suitable substrate, such as a glass substrate or a silicon substrate. In some embodiments, a release layer 501 may be formed on the first carrier substrate 500. The release layer 501 may comprise a material such as a polymer, wax, epoxy, or resin which acts as a sacrificial layer and may be cleanly removed from the first carrier substrate 500 and the fourth hybrid transceiver 400.

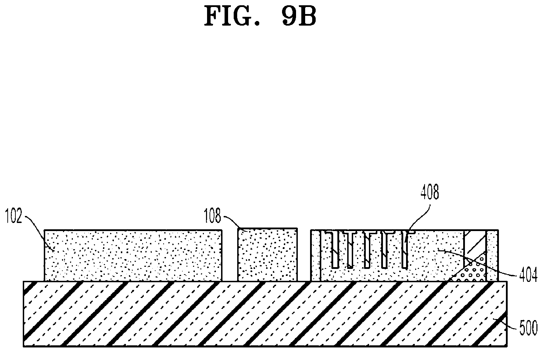

FIG. 9B depicts S1020 in the process of FIG. 10 where the first compute device 102, the one or more connecting elements 108 and the inverted PIC 404 are positioned upon the first carrier substrate 500. The first compute device 102, the one or more connecting elements 108 and the inverted PIC 404 may be formed on separate substrates and transferred to the first carrier substrate 500. The first compute device 102, the one or more connecting elements 108 and the inverted PIC 404 are positioned upon the first carrier substrate 500 such that the side which will contact the flat RDL 410 is oriented upwards, while the opposite side, which will be the "top" side of the fourth hybrid transceiver 400 is positioned towards the first carrier substrate 500. More than one of the flat base 401 may be formed together on the first carrier substrate 500, with the inverted PIC 404 of each of the flat base 401 coupled to a second of the inverted PIC 404. As such, the flat base 401 may be formed in mirror image pairs with each of the inverted PIC 404 positioned in mirror pairs.

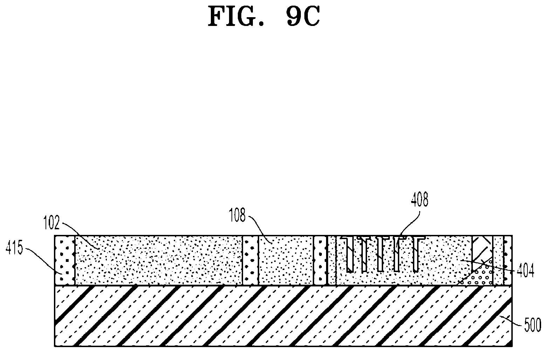

FIG. 9C depicts S1030 in the process of FIG. 10 where the flat molding layer 415 is formed to encapsulate the first compute device 102, the inverted PIC 404 and the one or more connecting elements 108. The flat molding layer 415 may provide thermal, electrical, and mechanical protection for the various components in and on the fourth hybrid transceiver 400. The flat molding layer 415 may be formed from a dielectric material such as silicon dioxide, resins, adhesives, and epoxies, alone or in combination, and may in some embodiments include an EMC. Furthermore, a planarization process may be used to smooth and or planarize the surface, the process including one or more grinding, polishing, and smoothing processes, including CMP.

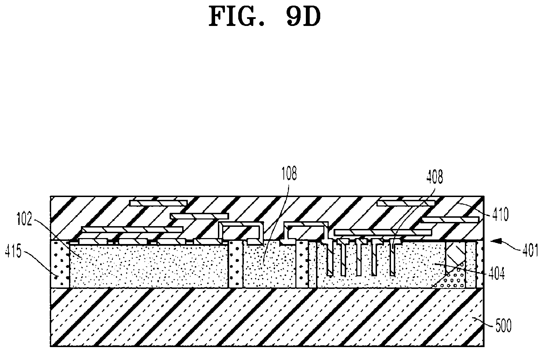

FIG. 9D depicts S1040 in the process of FIG. 10 where the flat RDL 410 is formed over the flat molding layer 415, the first compute device 102, the inverted PIC 404 and the one or more connecting elements 108. The flat RDL 410 may be formed using CMOS processes, such as depositing, lithography, etching, including both wet etch and dry etch, and passivation directly on the first carrier substrate 500. In some embodiments, the flat RDL 410 may be formed on a separate substrate and transferred to the first carrier substrate 500. The flat RDL 410 may thus couple the first compute device 102, the inverted PIC 404 and the one or more connecting elements 108 together, and form the flat base 401.

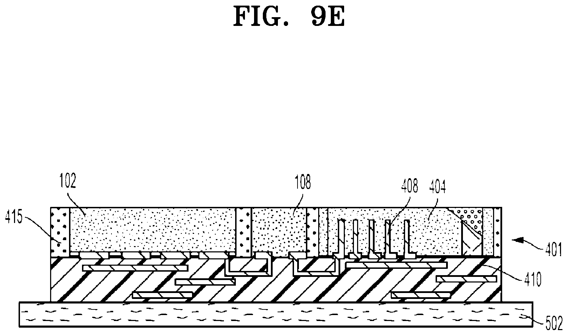

FIG. 9E depicts S1050 in the process of FIG. 10 where the flat base 401 is released from the first carrier substrate 500, and transferred to the dicing tape 502. The flat base 401 has its orientation vertically flipped so that the flat RDL 410 is positioned on the dicing tape 502. The dicing tape 502 is a CMOS compatible material including an adhesive layer allowing the flat base 401 to couple to the dicing tape 502.

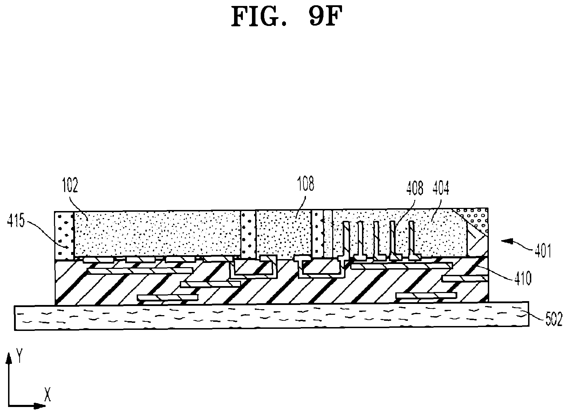

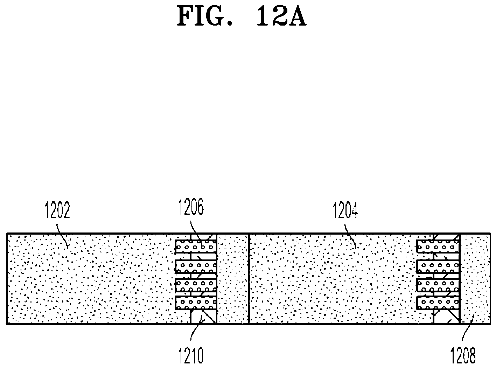

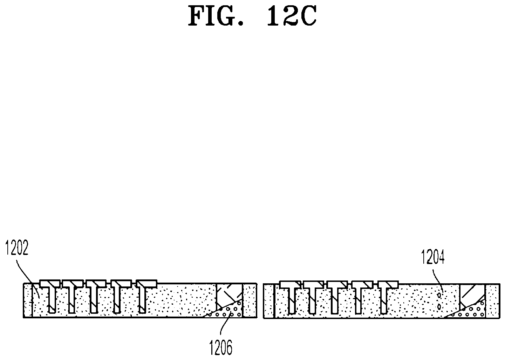

FIG. 9F depicts S1060 in the process of FIG. 10 where individual units are separated by dicing. The inverted PIC 404 may have any excessive portions removed using the dicing to provide access to the one or more optical ports 116. More than one of the flat base 401 may be formed together on the first carrier substrate 500, with the inverted PIC 404 of each of the flat base 401 coupled to a second of the inverted PIC 404. As such, the dicing may be performed between adjacent of the inverted PIC 404. The layout of such PICs is described in more depth in FIG. 12A-12C below. The dicing may be performed using a scribe step compatible with the dicing tape 502, such as mechanical separation using a blade or shear process, as well as other techniques such as using thermal or photonic energy.

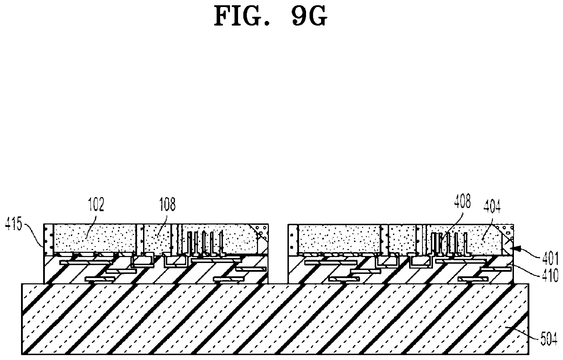

FIG. 9G depicts S1070 in the process of FIG. 10 where one or more of the flat base 401 are transferred from the dicing tape 502 to the second carrier substrate 504. The second carrier substrate 504 may be any suitable substrate, such as a glass substrate or a silicon substrate. In some embodiments, a release layer (not shown) may be formed on the second carrier substrate 504. The release layer may comprise a material such as a polymer, wax, epoxy, or resin which acts as a sacrificial layer and may be cleanly removed from the second carrier substrate 504 and the flat base 401.

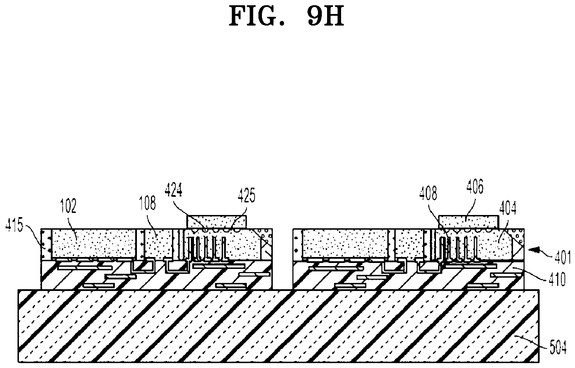

FIG. 9H depicts S1080 in the process of FIG. 10 where the positioned EIC 406 is positioned on the inverted PIC 404 using one or more positioned conductive connections 424 and one or more positioned dielectric bonds 425. The one or more positioned conductive connections 424 may include pads, bumps, microbumps, pillars, balls, ball grids, microball arrays, and other forms such as C4 bumps, alone or in combination. The one or more positioned dielectric bonds 425 may include a dielectric material or adhesive between positioned conductive connections 424, such as an epoxy, a resin, or other suitable material. In some embodiments, the one or more positioned dielectric bonds 425 may be formed using an underfill technique and inserted between positioned conductive connections 424 and around the one or more positioned conductive connections 424. In some embodiments, the one or more positioned conductive connections 424 and the one or more positioned dielectric bonds 425 may combine to form a hybrid bond between the inverted PIC 404 and the positioned EIC 406.

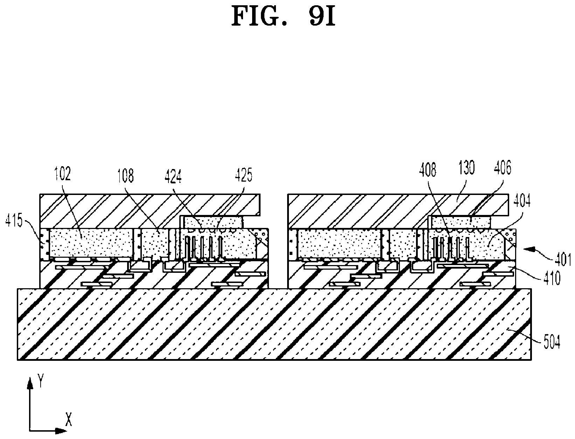

FIG. 9I depicts S1085 in the process of FIG. 10 where the dummy layer 130 is positioned on top of the first compute device 102, the one or more connecting elements 108 and the positioned EIC 406. The dummy layer 130 may be formed of a thermally conductive material, such as silicon, able to provide a thermal pathway and potentially dissipating heat. In some embodiments, the dummy layer 130 may be formed directly over the first compute device 102, the one or more connecting elements 108 and the positioned EIC 406, while in other embodiments one or more intermediate layers may be between the first compute device 102, the one or more connecting elements 108 and the positioned EIC 406 to bond the dummy layer 130 to the rest of the fourth hybrid transceiver 400. In some embodiments, the dummy layer 130 may be formed separately and positioned upon the first compute device 102, the one or more connecting elements 108 and the positioned EIC 406, while in other embodiments, the dummy layer 130 may be formed directly on top of the first compute device 102, the one or more connecting elements 108 and the positioned EIC 406 using a process such as deposition.

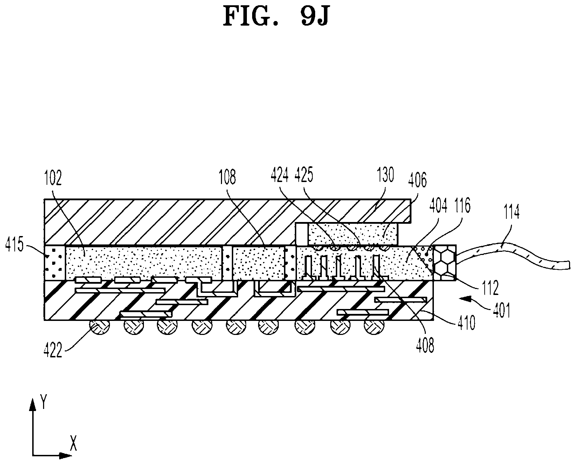

FIG. 9J depicts S1090 in the process of FIG. 10 where the fourth hybrid transceiver 400 is released from the second carrier substrate 504. Additionally, along with releasing the fourth hybrid transceiver 400 from the second carrier substrate 504, the transceiver interconnections 422 are formed on the flat base 401, and the first optical connection 114 may be positioned.

The second carrier substrate 504 may be released, for example, by using one or more of layer release, chemical release, thermal release, or photo release techniques to release an adhesive layer coupling the second carrier substrate 504 to the fourth hybrid transceiver 400. For example, in some embodiments a chemical release technique may use a solvent to dissolve the adhesive directly, while a thermal release technique may apply heat to the carrier wafer to melt the adhesive, and a photo release technique may use lasers to directly apply energy to the adhesive layer to reduce the adhesive strength.

The transceiver interconnections 422 include electrically conductive elements such as pads, bumps, microbumps, pillars, balls, ball grids, microball arrays, and other forms such as C4 bumps, alone or in combination. In some embodiments, the transceiver interconnections 422 may be formed separately and positioned as a unit to the support base 101. In other embodiments, one or more of the transceiver interconnections 422 may be formed directly on the flat RDL 410, such as by depositing a soldering material. The transceiver interconnections 422 may further be used to electrically couple the fourth hybrid transceiver 400 to the supporting substrate 120. In some embodiments, the transceiver bonding layer 423 between the flat base 401 and the supporting substrate 120 may include a dielectric material or an adhesive, like underfill material, to provide additional strength and connection between the flat base 401 and the supporting substrate 120. The supporting substrate 120 may be formed of any suitable material, and may include glass, silicon, as well as organic materials such as polymers.

The first optical connection 114 may optically couple to the inverted PIC 404 using one or more optical ports 116. In some embodiments, the one or more optical ports 116 may be v-grooves coupled to one or more waveguides within the inverted PIC 404. In some embodiments, an optical coupler 112 may be used to connect the first optical connection 114 to the one or more optical ports 116. In some embodiments, the optical coupler 112 may be a plug connector allowing the first optical connection 114 to be removably coupled to the one or more optical ports 116. In other embodiments, the optical coupler 112 may take the form of a pressurized component to secure the first optical connection 114 to the one or more optical ports 116, as well as take the form of an adhesive coupling the one or more optical ports 116 and the first optical connection 114, while in further embodiments, a combination thereof may be used.

In some embodiments, the optical coupler 112 may couple multiple fibers within the first optical connection 114 such that each fiber of the first optical connection 114 may couple directly with a corresponding optical port of the one or more optical ports 116. In some embodiments, the optical coupler 112 may be a FAU.

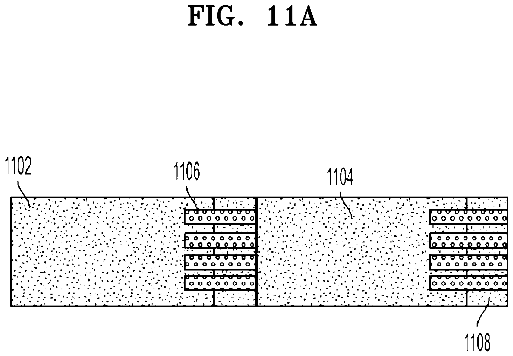

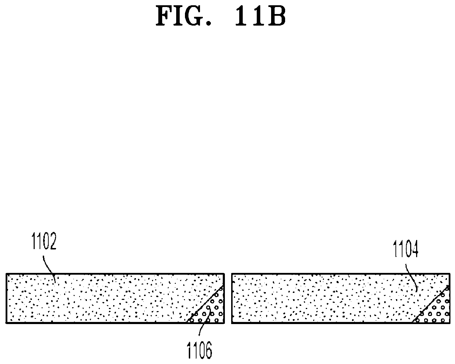

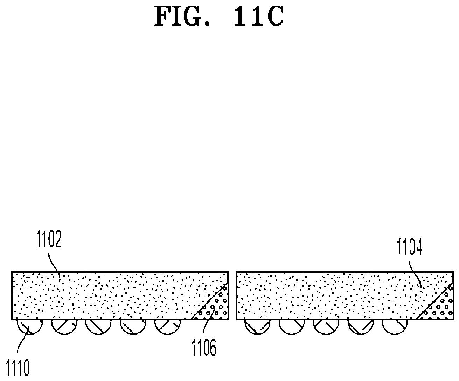

FIGS. 11A-11C depict an illustrative embodiment demonstrating the dicing process with respect to the process 600 to produce the first hybrid transceiver 100. One or more of the PIC 104 may be formed on a shared substrate using a process such as a front of line process. FIG. 11A provides an example of a plan view, while FIG. 11B provides an example of a cross-sectional view. In FIGS. 11A-11C, a first PIC 1102 and a second PIC 1104 are shown. Each of the first PIC 1102 and the second PIC 1104 include an optical coupling unit 1106 such as one or more V-grooves. The optical coupling unit 1106 may extend from within each of the PIC to a scribe lane 1108. After one of the PIC 104 are produced, a dicing process may separate the first PIC 1102 and the second PIC 1104, with the dicing performed in the scribe lane 1108.

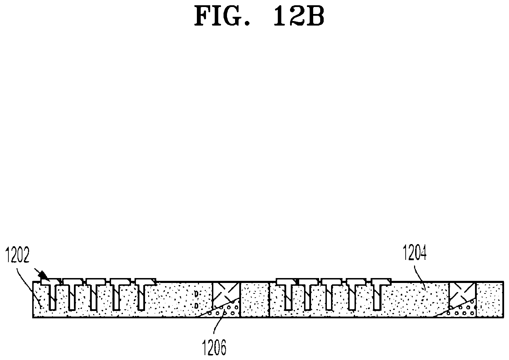

FIGS. 12A-12C depict an illustrative embodiment demonstrating the dicing process with respect to the process 1000 to produce the fourth hybrid transceiver 400. One or more of the inverted PICs 404 may be formed on a shared substrate using a process such as a front of line process. FIG. 12A provides an example of a plan view, while FIG. 12B provides an example of a cross-sectional view. In FIGS. 12A-12C, a first inverted PIC 1202 and a second inverted PIC 1204 are shown. Each of the first inverted PIC 1202 and the second inverted PIC 1204 include an inverted optical coupler 1206 such as one or more V-grooves. The inverted optical coupler 1206 may extend from within each of the PIC to an inverted scribe lane 1208. After the inverted PICs 404 are produced, a dicing process may separate the first inverted PIC 1202 and the second inverted PIC 1204, with the dicing performed in the inverted scribe lane 1208. In the fourth hybrid transceiver 400, the inverted optical coupler 1206 may have a sacrificial section 1210 between each of the inverted PIC and the corresponding one of the inverted scribe lane 1208. As the fourth hybrid transceiver 400 uses the inverted PIC 404, portions of the inverted optical coupler 1206 may extend beyond the rest of the body of the inverted PIC 404. As such, the sacrificial section 1210 may prevent damage to the inverted optical coupler 1206 during a dicing process.

While this specification may contain many specific implementation details, the implementation details should not be construed as limitations on the scope of any claimed subject matter, but rather be construed as descriptions of features specific to particular embodiments. Certain features that are described in this specification in the context of separate embodiments may also be implemented in combination in a single embodiment. Conversely, various features that are described in the context of a single embodiment may also be implemented in multiple embodiments separately or in any suitable subcombination. Moreover, although features may be described above as acting in certain combinations and even initially claimed as such, one or more features from a claimed combination may in some cases be excised from the combination, and the claimed combination may be directed to a subcombination or variation of a subcombination.

Similarly, while operations are depicted in the drawings in a particular order, this should not be understood as requiring that such operations be performed in the particular order shown or in sequential order, or that all illustrated operations be performed, to achieve desirable results. In certain circumstances, multitasking and parallel processing may be advantageous. Moreover, the separation of various system components in the embodiments described above should not be understood as requiring such separation in all embodiments, and it should be understood that the described program components and systems can generally be integrated together in a single software product or packaged into multiple software products.

Thus, particular embodiments of the subject matter have been described herein. Other embodiments are within the scope of the following claims. In some cases, the actions set forth in the claims may be performed in a different order and still achieve desirable results. Additionally, the processes depicted in the accompanying figures do not necessarily require the particular order shown, or sequential order, to achieve desirable results. In certain implementations, multitasking and parallel processing may be advantageous.

## Claims

1. A device (100-400) comprising:
a first layer including a photonic integrated circuit (104) and a first compute device (102), the photonic integrated circuit (104) including an output port (116) coupled to an optical fiber (114);
a second layer including a support base (101) with the first layer positioned on the support base (101); and
a connecting element (108) coupling the photonic integrated circuit (104) and the first compute device (102),
wherein the output port (116) extends in a direction parallel with the first layer beyond the support base (101).

2. The device (100-400) of claim 1, wherein the first compute device (102) includes at least one processing device and/or an auxiliary processing unit.

3. The device (100-400) of claim 1 or 2, wherein the output port (116) comprises one or more V-grooves extending in a direction parallel with the first layer.

4. The device (100-400) of any one of claims 1 to 3, wherein the photonic integrated circuit (104) includes a plug connector (112) configured to receive an optical fiber (114), in particular in a direction parallel with the first layer.

5. The device (100-400) of any one of claims 1 to 4, wherein the connecting element (108) is arranged between the first compute device (102) and the photonic integrated circuit (104), and the connecting element (108) is arranged within the support base or within the first layer.

6. The device (100-400) of any one of claims 1 to 5, further comprising an electronic integrated circuit (106) positioned on a side of the photonic integrated circuit (104) opposite the support base or arranged between the photonic integrated circuit (104) and the support base.

7. The device (100-400) of any one of claims 1 to 6, further comprising:
a redistribution layer (110) arranged on the connecting element (108), the first compute device (102), and the photonic integrated circuit,
the first layer is positioned upon the redistribution layer (110), and preferably the connecting element (108) is between the photonic integrated circuit (104) and the first compute device (102), and
wherein the redistribution layer (110) couples the photonic integrated circuit (104) to the connecting element (108) and couples the first compute device (102) to the connecting element (108).

8. The device (100-400) of claim 7, wherein the photonic integrated circuit (104) includes an optical coupler (112) extending in a direction parallel to the first layer.

9. The device (100-400) of claim 8, wherein the optical coupler (112) extends in the first layer in a direction parallel to the first layer beyond the redistribution layer (110).

10. The device (100-400) of any one of claims 7 to 9, further comprising an electronic integrated circuit (106) positioned on a side of the photonic integrated circuit (104) opposite the redistribution layer (110).

11. A method comprising:
forming a first layer including a connecting element (108);
forming a redistribution layer (110) on the first layer;
positioning a first compute device (102) on the redistribution layer (110);
coupling the first compute device (102) to the connecting element (108) via the redistribution layer (110);
positioning a photonic integrated circuit (104) on the redistribution layer (110) with a portion of the photonic integrated circuit (104) extending beyond the redistribution layer (110) in a direction parallel to the redistribution layer (110);
coupling the photonic integrated circuit (104) to the connecting element (108) via the redistribution layer (110); and
positioning an electronic integrated circuit (106) on the photonic integrated circuit (104).

12. The method of claim 11, wherein the first compute device (102) includes at least one processing unit.

13. The method of claim 11 or 12, further comprising coupling an optical fiber (114) in a direction parallel to the photonic integrated circuit (104).

14. The method of any one of claims 11 to 13, further comprising positioning the first layer on a supporting substrate (120),
wherein the supporting substrate (120) is an organic substrate.

15. The method of any one of claims 11 to 14, wherein the photonic integrated circuit (104) includes a v-groove extending in a direction parallel to the first layer.
